# FASCICULE DE BREVET EUROPEEN

(11) **EP 2 145 360 B1**
(45) Date de publication et mention de la délivrance du brevet: **20.05.2015**
(21) Numéro de dépôt: 08736525.0
(22) Date de dépôt: 24.04.2008
(51) Int. Cl.: H01M 10/663, H01M 2/20, H01M 2/30, H01M 10/42, H01M 10/625, H01M 10/613, H01M 10/643, H01M 10/6554, H01M 10/6567, H01M 10/6563, H01M 10/052, H01M 2/10

(54) **MODULE POUR ENSEMBLE DE STOCKAGE D'ENERGIE ELECTRIQUE.**
MODUL FÜR EINE ELEKTRISCHE ENERGIESPEICHERBAUGRUPPE
MODULE FOR AN ELECTRIC ENERGY STORAGE ASSEMBLY

(30) Priorité: 24.04.2007 FR 0754650
(43) Date de publication de la demande: 20.01.2010
(73) Titulaire: Blue Solutions, 29500 Ergué Gabéric (FR)
(72) Inventeur: CAUMONT, Olivier, F-29000 Quimper (FR); JUVENTIN-MATHES, Anne-Claire, F-29000 Quimper (FR); LE BRAS, Karine, F-29820 Guilers (FR); DEPOND, Jean-Michel, F-29000 Quimper (FR)
(74) Mandataire: Regimbeau
(86) Numéro de dépôt international: PCT/EP2008/054971
(87) Numéro de publication internationale: WO 2008/132122

(56) Documents cités:
- US-A1- 2002 043 959
- US-A1- 2003 013 009
- US-A1- 2005 174 092
- US-A1- 2006 164 812

## Description

La présente invention concerne le domaine technique général des ensembles de stockage d'énergie électrique.

Plus particulièrement l'invention concerne le domaine des modules comprenant au moins deux ensembles de stockage d'énergie électrique.

On entend, dans le cadre de la présente invention, par « ensemble de stockage d'énergie électrique », soit un condensateur (i.e. un système passif comprenant deux électrodes et un isolant), soit un supercondensateur (i.e. un système comprenant deux électrodes, un électrolyte et un séparateur), soit une batterie de type batterie au lithium (i.e. un système comprenant une anode, une cathode et une solution d'électrolyte entre l'anode et la cathode).

### PRESENTATION GENERALE DE L'ART ANTERIEUR

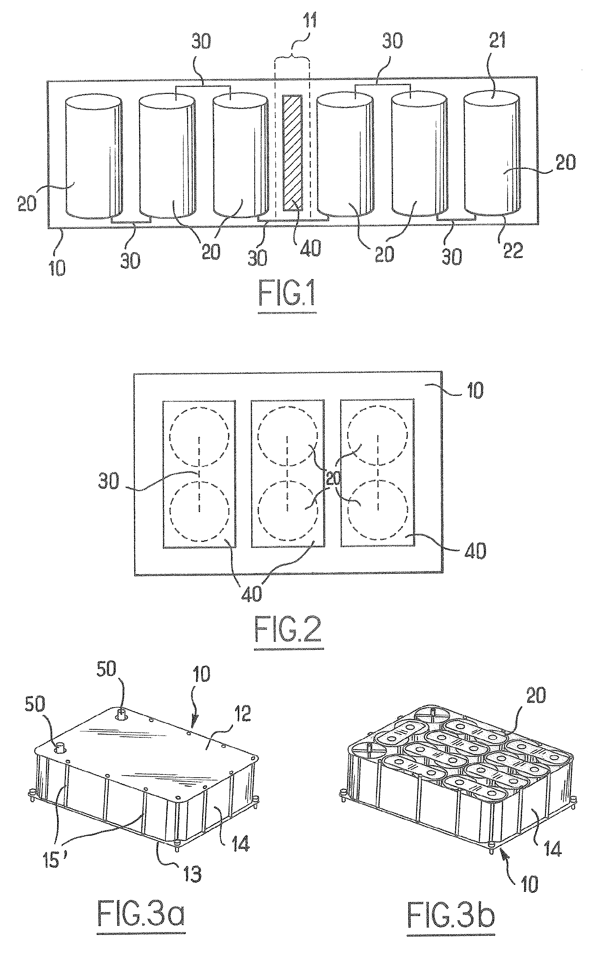

On connaît des modules tels que représentés à la figure 1, comprenant un boîtier 10 dans lequel sont disposés plusieurs ensembles de stockage d'énergie électrique 20 reliés par des moyens de connexion 30.

Ces modules comprennent généralement une carte électronique de gestion 40 pour la gestion de la charge et de la décharge des ensembles de stockage d'énergie électrique 20.

Comme illustré schématiquement à la figure 1, dans un mode de réalisation d'un module de l'art antérieur, les ensembles de stockages 20 sont de forme cylindriques et reliés deux à deux alternativement au niveau de leurs disques supérieurs 21 et inférieurs 22.

La carte électronique de gestion 40 est disposée dans une région centrale 11 du boîtier 10.

Comme illustré en vue de dessus à la figure 2, dans un autre mode de réalisation, le module comprend une pluralité de cartes électroniques de gestion 40 collées sur les moyens de connexion 30, dans la portion inférieure du boîtier 10.

Dans les deux modes de réalisation décrits ci-dessus, les moyens de connexion 30, les ensembles de stockage d'énergie 20 et la (ou les) carte(s) électronique(s) de gestion 40 produisent de la chaleur.

On a déjà proposé des dispositifs permettant de dissiper la chaleur produite dans de tels modules.

Le document US 2003/013009 décrit un module comprenant une carte électronique et un ensemble de batteries électriquement connectées en série ou en parallèle. Les batteries de l'ensemble de batteries sont en contact thermique avec des parois d'un logement du module par l'intermédiaire de plaques de transfert de chaleur. La carte électronique n'est en contact avec aucune des parois du logement.

Le document US 2006/0164812 décrit un système de dissipation de chaleur. Ce système peut être utilisé dans un module comprenant un boîtier, des ensembles de stockage à l'intérieur du boîtier, et des cartes électroniques à l'extérieur du boîtier, les ensembles de stockage et les cartes électroniques étant en contact avec les mêmes parois du boîtier.

Le document US 2006/141348 décrit un module comprenant des batteries et des circuits électroniques disposés à l'intérieur d'un logement. Ce module est conçu pour assurer une dissipation de la chaleur générée à l'intérieur du logement au niveau de la face arrière de celui-ci grâce à des plaques thermiques.

Le document US 2002/043959 décrit un module comprenant un logement dans lequel sont disposés des plateaux à transfert de chaleur destinés à recevoir un groupe de batteries et une carte électronique assurant la charge et la décharge du groupe de batteries. Les plateaux à transfert de chaleur permettent de véhiculer la chaleur produite par le groupe de batteries et la carte électronique vers les parois supérieure et inférieure du logement.

Le document US 2006/174092 (ci-après D3) décrit une batterie lithium incluant un logement, une pluralité de cellules, et un dispositif électronique pour la gestion des cellules. Seules les cellules sont en contact thermique avec des parois du logement de la batterie par l'intermédiaire d'éléments.

Toutefois les solutions présentées ci-dessus ne permettent pas une gestion thermique suffisante.

En effet, la chaleur produite par les ensembles de stockage d'énergie n'est pas suffisamment évacuée vers l'extérieur.

Or la température est un facteur important de vieillissement des ensembles de stockage d'énergie.

Le but général de l'invention est de proposer un module permettant de pallier l'inconvénient des modules existants.

### PRESENTATION DE L'INVENTION

A cet effet on prévoit un module comprenant un boîtier dans lequel sont disposés au moins deux ensembles de stockage d'énergie électrique reliés par des moyens de connexion et au moins une carte électronique de gestion pour la gestion d'énergie et le diagnostic pour la gestion de la charge et de la décharge des ensembles de stockage d'énergie, dans lequel des parois différentes du boîtier sont en contact thermique tout en étant en isolation électrique respectivement :
- pour au moins une paroi avec des éléments de dissipation thermique liés aux ensembles de stockage d'énergie électrique,
- pour au moins une autre paroi avec la carte électronique de gestion,
de sorte à favoriser le refroidissement dudit module.

Ainsi, le fait d'associer (par l'intermédiaire des éléments de dissipation thermique) les ensembles de stockage à une première paroi du boîtier, et la carte électronique à une deuxième paroi (différente de la première paroi) permet de favoriser l'évacuation vers l'extérieur, de la chaleur produite à l'intérieur du module par la (ou les) carte(s) électronique(s) de gestion, les moyens de connexion et les ensembles de stockage.

Aucun des documents US 2003/013009, US 2006/0164812, US 2006/141348 et US 2002/043959 ne décrit un module dans lequel la carte électronique et les ensembles de stockage sont en contact thermique tout en étant en isolation électrique avec des parois différentes du boîtier du module de sorte que la chaleur générée par ces éléments est dissipée par des parois différentes du boîtier. Cette caractéristique de l'invention permet une évacuation de la chaleur produite à l'intérieur du boîtier plus efficace qu'avec les modules de l'art antérieur.

Des aspects préférés mais non limitatifs du module selon l'invention sont les suivants :
- le boîtier comprend des ailettes sur au moins une face extérieure du boîtier :
   on appellera ici ailettes tout dispositif permettant d'augmenter la surface d'échange convectif d'une pièce. On considérera que des raidisseurs de parois, tout aussi bien que des lames de radiateurs, peuvent constituer des ailettes au sens du présent brevet ;
   ceci permet d'augmenter la surface de contact entre le boîtier et le milieu extérieur afin de favoriser les échanges thermiques avec l'extérieur et
   ainsi améliorer le refroidissement de l'intérieur du module ;
- les ailettes sont disposées sur la face externe d'au moins une paroi du boîtier en contact thermique avec les éléments de dissipation thermique liés aux ensembles de stockage :
   ceci permet d'améliorer le refroidissement des ensembles de stockage ;
- les ailettes sont disposées sur la face externe d'au moins une autre paroi du boîtier en contact thermique avec la carte électronique de gestion :
   ceci permet d'améliorer le refroidissement de la carte électronique ;
- le boîtier peut être en aluminium, ou en matériau composite carboné :
   ceci permet d'améliorer la conduction thermique entre l'intérieur et l'extérieur du boîtier par rapport à des boîtiers en plastique ou en acier, à caractéristiques mécaniques équivalentes;
- la paroi en contact avec les éléments de dissipation thermique est la paroi inférieure et/ou supérieure du boîtier et l'autre paroi en contact avec la carte électronique de gestion est une paroi latérale du boîtier :
   ceci permet, par exemple dans le cas d'ensembles de stockage cylindriques ou parallélépipédiques disposés parallèlement les uns aux autres et parallèlement aux parois latérales du boîtier, d'améliorer le refroidissement des ensembles de stockage, un refroidissement axial des ensembles de stockage étant plus efficace qu'un refroidissement radial ;
- la paroi en contact thermique avec les éléments de dissipation thermique peut comprendre, ou être associé à, un socle dans lequel est disposé un dispositif de refroidissement :
   ceci permet d'améliorer le refroidissement des ensembles de stockage ;
- le dispositif de refroidissement peut comprendre un circuit de circulation d'un fluide de refroidissement :
   ceci permet d'augmenter les échanges thermiques entre l'intérieur et l'extérieur du module ;
- la carte électronique de gestion comprend une couche de résine époxy sur laquelle est collé un circuit imprimé en cuivre, la couche de résine époxy étant en contact avec la face interne de l'autre paroi du boîtier :
   la couche de résine époxy permet la mise en contact thermique tout en assurant l'isolation électrique du circuit imprimé en cuivre avec le boîtier ;
- la carte électronique de gestion comprend une plaque en aluminium sur la couche de résine époxy, la plaque en aluminium étant en contact avec la face interne de l'autre paroi du boîtier :
   la plaque en aluminium permet de favoriser l'évacuation de la chaleur produite par le circuit imprimé en cuivre vers la paroi du boîtier ;
- deux parois sont en contact thermique tout en étant en isolation électrique avec les éléments de dissipation thermique liés aux ensembles de stockage d'énergie :
   ceci permet d'augmenter la surface d'échange thermique entre le boîtier et les ensembles de stockage et ainsi d'améliorer le refroidissement des ensembles de stockage ;
- les deux parois en contact thermique avec les éléments de dissipation thermique liés aux ensembles de stockage d'énergie sont les parois supérieure et inférieure du boîtier ;
- le module comprend au moins une carte électronique de gestion, ladite carte électronique de gestion étant en contact avec au moins une paroi latérale du boîtier ;
- le module comprend autant de cartes électroniques de gestion que le boîtier comporte de parois latérales, chacune desdites cartes étant en contact avec une paroi latérale respective du boîtier :
   ceci permet d'améliorer le refroidissement des cartes électroniques, d'optimiser le volume du module et de contribuer à l'homogénéisation des températures au sein du module, les cartes électroniques jouant alors le rôle de tampon thermique en évitant de creuser l'écart de température des éléments entre le coeur du module et les éléments situés en périphérie, vis à vis des modules de l'état de l'art, où des cartes disposées au centre, au dessus ou dessous du module accentuaient l'écart de température ressenti par les éléments centraux et les éléments de périphérie; cette disposition a une conséquence importante sur la durée de vie globale du module, elle-même fortement liée aux déséquilibres de température que peuvent subir les différents éléments du module ; avantageusement, les cartes de connexion peuvent être en contact avec la face interne de la paroi latérale du boîtier ou avec la face externe de la paroi latérale du boîtier.
- les moyens de connexion entre deux ensembles de stockage adjacents comprennent deux couvercles reliés électriquement par une barrette, chaque couvercle comprenant une borne de connexion destinée à être en contact avec un alésage traversant de la barrette ;les moyens de connexion entre deux ensembles de stockage adjacents comprennent deux couvercles reliés électriquement par une barrette, chaque couvercle qui pouvant être soudé laser par transparence, brasés ou liés par brasage-diffusion à la barrette ;
- l'alésage traversant la barrette possède une rugosité de surface élevée pour favoriser le contact électrique avec la borne de connexion ;
- la surface de contact entre la barrette et un couvercle est préférentiellement supérieure ou égale à un quart de la surface du couvercle et encore plus préférentiellement supérieure ou égale à la moitié de la surface du couvercle ;
- les barrettes peuvent également être en cuivre ;
   ceci permet de diminuer la résistance ohmique des moyens de connexion et ainsi de minimiser les pertes par effet Joule et donc la chaleur produite par les moyens de connexion ;
- les barrettes sont en aluminium :
   ceci permet d'améliorer la conduction thermique entre les ensembles de stockage et le boîtier et de diminuer la masse des éléments de connexion ;
- les barrettes en cuivre (ou en aluminium) peuvent comporter un étamage à titre de protection de surface ;
- deux ensembles de stockage adjacents sont reliés électriquement par une pièce longitudinale dont les extrémités forment les couvercles, respectivement supérieurs ou inférieurs de chacun des ensembles de stockage adjacents de manière à connecter électriquement lesdits ensembles de stockage adjacents ;
   ceci permet de maximiser la surface de contact entre les éléments de stockage d'énergie et les parois du boîtier pour favoriser la diffusion thermique vers le boîtier, tandis que l'utilisation de moyens de connexion réalisés en une seule pièce permet de diminuer la résistance interne des moyens de connexion (et donc la production de chaleur par effet Joule) ;
- chaque extrémité de la pièce longitudinale comprend des zones préférentielles amincies ;
- les moyens de connexion entre deux ensembles de stockage adjacents peuvent comprendre deux couvercles reliés électriquement par une barrette soudée laser par transparence ; dans ce cas, le soudage de la barrette peut être effectué au travers de zones préférentielles amincies ;
- les moyens de connexion entre deux ensembles de stockage adjacents peuvent comprendre deux couvercles reliés électriquement par une barrette brasée sur les couvercles ;
- les moyens de connexion entre deux ensembles de stockage adjacents comprennent deux couvercles reliés électriquement par une barrette par brasage-diffusion de la barrette sur les couvercles ;
- la surface de contact entre la barrette et un couvercle est préférentiellement supérieure ou égale à un quart de la surface du couvercle, et encore plus préférentiellement supérieure ou égale à la moitié de la surface du couvercle ;
- deux ensembles de stockage adjacents peuvent être reliés électriquement par une pièce longitudinale dont les extrémités forment les couvercles, respectivement supérieurs ou inférieurs de chacun des ensembles de stockage adjacents de manière à connecter électriquement lesdits ensembles de stockage adjacents ; dans ce cas, chaque extrémité de la pièce longitudinale comprend des zones préférentielles amincies radiales ;
- les zones préférentielles amincies peuvent être perpendiculaires deux à deux et avoir un angle de 45° avec l'axe longitudinal B-B de la pièce ;
- les zones préférentielles amincies peuvent être perpendiculaires deux à deux, au moins une zone de chaque extrémité s'étendant selon l'axe longitudinal B-B de la pièce ;
- les moyens de connexion peuvent comprendre les éléments de dissipation thermique ;
- les éléments de dissipation thermique peuvent comprendre une couche d'élastomère :
   la couche en élastomère permet d'isoler électriquement et de relier thermiquement les ensembles de stockage au boîtier.

### PRESENTATION DES FIGURES

D'autres caractéristiques, buts et avantages de la présente invention ressortiront encore de la description qui suit, laquelle est purement illustrative et non limitative et doit être lue en regard des dessins annexés sur lesquels :
- la figure 1 illustre un mode de réalisation d'un module de l'art antérieur,
- la figure 2 illustre un autre mode de réalisation d'un module de l'art antérieur,
- les figures 3a à 3d illustrent un mode de réalisation d'un module selon l'invention,
- la figure 4 illustre un autre mode de réalisation du module,
- la figure 5 illustre des ailettes d'un mode de réalisation du module,
- les figures 6 à 9 illustrent des exemples de moyens de connexion des éléments de stockage d'énergie entre eux à l'intérieur du module,
- les figures 10 et 11 illustrent des exemples de carte électronique de gestion du module.

### DESCRIPTION DE L'INVENTION

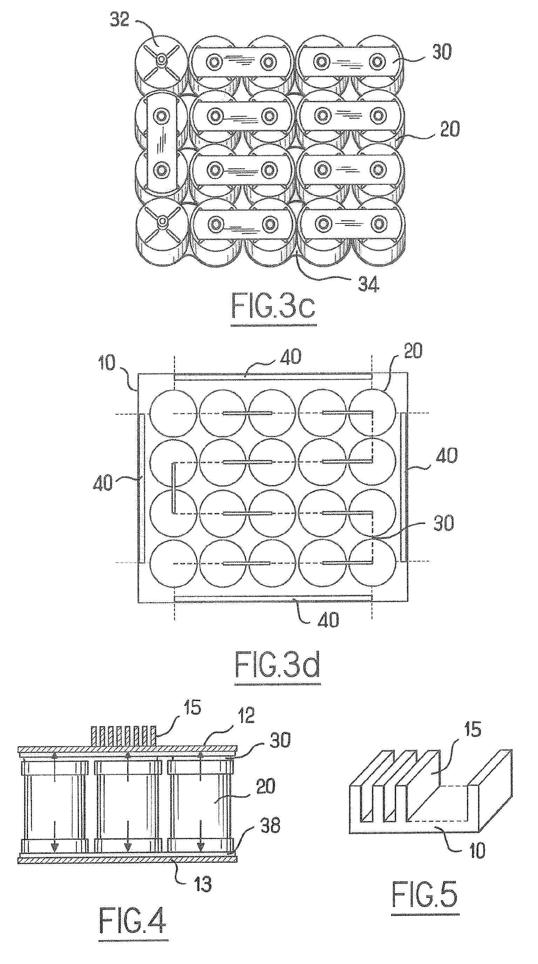

On va maintenant décrire différents modes de réalisation du module selon l'invention en référence aux figures 3 à 11. Dans ces différentes figures, les éléments équivalents du module portent les mêmes références numériques.

En référence à la figure 3a, on a illustré un mode de réalisation du module destiné à être connecté par des bornes de tension 50 à un dispositif annexe (non représenté).

Le module comprend un boîtier 10 dans lequel sont disposés des ensembles de stockage d'énergie électrique 20 reliés par des moyens de connexion 30.

Le module comprend également une carte électronique de gestion 40 pour la gestion d'énergie et le diagnostic des ensembles de stockage d'énergie 20.

Les ensembles de stockage 20 sont de forme globalement cylindrique. Les ensembles de stockage 20 sont disposés côte à côte dans le boîtier 10. En d'autres termes, les axes de révolution des ensembles de stockage 20 sont parallèles. Dans d'autres variantes non représentées ici, les éléments de stockage peuvent être de forme parallélépipédique, carrée, ovale, hexagonale, sans que cela change les principes généraux de l'invention.

Dans le mode de réalisation illustré aux figures 3a à 3d, les ensembles de stockage 20 sont disposés de sorte que leurs axes de révolution sont perpendiculaires aux parois supérieure 12 et inférieure 13 du boîtier 10.

Avantageusement, des parois différentes 12, 13, 14 du boîtier 10 sont en contact thermique tout en étant en isolation électrique respectivement :
- pour au moins une paroi avec des éléments de dissipation thermique liés aux ensembles de stockage d'énergie électrique,
- pour au moins une autre paroi avec la carte électronique de gestion.

Ceci permet de favoriser le refroidissement du module.

En effet, la connexion thermique des ensembles de stockage 20 avec une première paroi 12, 13 et de la carte électronique de gestion 40 avec une deuxième paroi 14 différente de la première paroi 12, 13 permet de maximiser la dissipation thermique de la chaleur émise par la carte 40 et les ensembles de stockage 20 vers l'extérieur du module.

Les éléments de dissipation thermique peuvent comprendre les moyens de connexion 30.

Les éléments de dissipation 38 peuvent également comprendre une couche en élastomère disposée entre les moyens de connexion 30 et la paroi du boîtier en contact thermique avec les ensembles de stockage 20.

La couche d'élastomère couvre plusieurs fonctions simultanément.

Elle permet:
- l'isolation électrique des ensembles de stockage 20 vis-à-vis du boîtier 10 grâce à une tension de claquage supérieure à 1 kV,
- l'absorption des dispersions géométriques des ensembles de stockage 20 dues aux tolérances de fabrication, grâce à son aptitude à la compression,
- l'amélioration des échanges thermiques entre les ensembles de stockage 20 et l'extérieur du module.

Dans un mode de réalisation avantageux, la paroi en contact avec les éléments de dissipation thermique est la paroi inférieure 13 du boîtier 10, et la paroi en contact avec la carte électronique de gestion 40 est une paroi latérale 14 du boîtier 10.

En effet, les ensembles de stockage 20 conduisent préférentiellement de la chaleur selon leur axe de révolution (axe longitudinal), de sorte qu'un refroidissement axial des ensembles de stockage 20 est plus efficace qu'un refroidissement radial de ceux-ci.

Selon le mode de réalisation, les ensembles de stockage 20 sont reliés thermiquement soit à la paroi supérieure 12, soit à la paroi inférieure 13, soit aux parois supérieure et inférieure 12, 13 du boîtier 10.

Dans le mode de réalisation illustré à la figure 4, les ensembles de stockage 20 sont reliés thermiquement aux parois supérieure et inférieure 12, 13.

La mise en contact thermique des ensembles de stockage avec deux parois permet d'améliorer le refroidissement des ensembles de stockage par une augmentation de la surface d'échange thermique entre les ensembles de stockage 20 et l'extérieur du module.

### Le boîtier

Le boîtier 10 permet la manutention du module, renforce l'isolation électrique et protège le coeur du module et son électronique des agressions potentielles extérieures.

Ce boîtier peut être parallélépipédique, pour être disposé à la place utilisée actuellement par une batterie de véhicule automobile , ou cylindrique, par exemple pour être logé dans l'espace libéré par une roue de secours , ou encore prismatique, définissant dans tous les cas des faces supérieure et inférieure, et des faces latérales.

Dans un mode de réalisation, les parois supérieure 12, inférieure 13 et latérales 14 du boîtier 10 sont en aluminium anodisé pour favoriser le refroidissement du module d'une part, via une meilleure dissipation radiative, et pour renforcer la tenue à la corrosion du module d'autre part.

Ainsi, l'utilisation de parois 12, 13, 14 en aluminium ou en matériau composite carboné permet d'améliorer la conduction thermique entre l'intérieur et l'extérieur du boîtier par rapport à des parois en matériau plastique ou en acier à caractéristiques mécaniques identiques. Ceci augmente l'efficacité du refroidissement des ensembles de stockage 20 et de la carte électronique 40.

Dans certaines variantes de réalisation de l'invention, le boîtier 10 comprend des ailettes 15 comme représenté aux figures 4 et 5.

Ces ailettes permettent d'augmenter la surface de contact entre le boîtier 10 et le milieu extérieur afin de favoriser les échanges thermiques avec l'extérieur. Ceci permet d'améliorer le refroidissement du module.

Les ailettes 15 peuvent être disposées sur au moins une face extérieure d'une paroi 12, 13, 14 du boîtier 10. Les raidisseurs 15' disposés sur les parois latérales constituent également des ailettes au sens du présent brevet puisqu'ils permettent d'augmenter la surface d'échange convectif des parois.

Par exemple, dans un mode de réalisation, les ailettes 15 sont disposées sur la face externe de la paroi du boîtier en contact thermique avec les ensembles de stockage 20 de sorte à améliorer le refroidissement desdits ensembles de stockage 20.

Dans le mode de réalisation illustré à la figure 4, les ailettes 15 sont disposées dans une région centrale 11 de la face externe de la paroi supérieure 12 du boîtier 10.

Ceci permet de faciliter l'évacuation de la chaleur produite par les ensembles 20 situés au centre du boîtier 10 (i.e. les ensembles 20 les plus éloignés des parois latérales 14), et pour lesquels l'évacuation de la chaleur est plus difficile que pour les ensembles 20 situés à la périphérie du boîtier 10 (i.e. les ensembles 20 les plus proches des parois latérales 14).

Dans un autre mode de réalisation, les ailettes 15 sont disposées sur la face externe de la paroi du boîtier 10 en contact thermique avec la carte électronique de gestion 40 de sorte à améliorer le refroidissement de ladite carte électronique de gestion 40.

Avantageusement, dans un autre mode de réalisation, les faces externes des parois 12, 13, 14 en contact thermique avec les ensembles de stockage 20 d'une part et la (ou les) carte(s) électronique(s) 40 d'autre part comprennent des ailettes 15.

Dans le cas où plusieurs parois du boîtier sont en contact thermique avec les ensembles de stockage et/ou la (ou les) carte(s) électronique(s) de gestion, toutes ces parois en contact thermique, ou seulement certaines de ces parois peuvent comprendre des ailettes sur leur face externe.

Pour améliorer encore l'évacuation de la chaleur produite par les ensembles de stockage 20, dans une variante de réalisation de l'invention, la paroi en contact thermique avec les ensembles de stockage 20 comprend, ou est associé à, un socle (non représenté) dans lequel est disposé un dispositif de refroidissement (non représenté).

Le dispositif de refroidissement peut comprendre un circuit de circulation d'un fluide de refroidissement.

Dans le cas où plusieurs parois du boîtier sont en contact thermique avec les ensembles de stockage, le module peut comprendre un dispositif de refroidissement dans une seule ou dans toutes les parois en contact thermique avec les ensembles 20.

Ceci permet d'améliorer le refroidissement du module en bénéficiant d'un système externe de refroidissement, d'un véhicule utilisant le module par exemple, tel qu'un circuit de climatisation du véhicule.

### Ensemble de stockage d'énergie électrique

Dans le mode de réalisation illustré aux figures 3a à 3d, le module comprend vingt ensembles de stockage d'énergie électrique 20. Les ensembles de stockage sont de forme globalement cylindrique.

Les ensembles de stockage 20 sont disposés dans le boîtier 10, parallèlement les uns aux autres et parallèlement aux parois latérales du boîtier. En d'autres termes, les axes de révolution des ensembles de stockage 20 sont parallèles entre eux et parallèles à chaque plan dans lequel s'étend une paroi latérale respective.

Dans le mode de réalisation illustré aux figures 3a à 3d, les ensembles de stockage 20 sont disposés de sorte que leurs axes de révolution sont perpendiculaires aux parois supérieure 12 et inférieure 13 du boîtier 10.

Les ensembles de stockage 20 sont connectés deux à deux par les moyens de connexions 30 qui seront décrits en détail dans la suite de la description.

On notera que dans le mode de réalisation illustré aux figures 3a à 3d, les vingt ensembles de stockage d'énergie électrique 20 sont reliés en série.

Ces ensembles de stockage 20 sont reliés deux à deux alternativement au niveau de leurs couvercles supérieurs 32 et inférieurs 32'. En d'autres termes, en se référant à un ensemble de stockage, celui-ci est relié par son couvercle supérieur à un premier ensemble de stockage adjacent, et par son couvercle inférieur à un deuxième ensemble de stockage adjacent différent du premier ensemble de stockage.

Bien évidemment, d'autres configurations que la configuration en série peuvent être adoptées en fonction de l'application. Par exemple, dans un module comprenant vingt ensembles de stockage 20, on peut relier en série une paire de dix ensembles de stockage 20 en série, et relier ensuite cette paire en parallèle, etc.

Les ensembles de stockages sont isolés électriquement des parois 12, 13, 14 du boîtier 10.

### Carte électronique de gestion

Dans le mode de réalisation illustré aux figures 3a à 3d, le dispositif comprend également quatre cartes électroniques de gestion 40.

La carte électronique de gestion 40 permet de gérer la charge et la décharge et le diagnostic des ensembles de stockage d'énergie 20. Par diagnostic, on entend ici l'ensemble des mesures de température, pression, tension et courant permettant de mesure et/ou de calculer l'état de charge ou l'état de santé du module au cours de sa vie active.

Notamment, la carte électronique permet de satisfaire deux besoins distincts :
- l'équilibrage des tensions de fin de charge des ensembles de stockage 20 du module,
- l'instrumentation en tension du module.

En effet, les éléments de stockage 20 ont des caractéristiques (capacité, résistances) présentant des dispersions dues à la fabrication, et/ou au vieillissement, etc.

Ces différences font que lors de la charge du module, tous les ensembles de stockage 20 ne possèdent pas la même tension de charge.

L'équilibrage comprend donc l'homogénéisation de ces tensions autour d'une même valeur de tension définie en fonction de l'application visée.

La carte électronique de gestion est connectée en parallèle des ensembles de stockage associés en série.

La carte électronique de gestion 40 est isolée électriquement des parois du boîtier 10.

Une carte électronique de gestion 40 comprend une couche de résine époxy 42 sur laquelle est collée un circuit imprimé en cuivre 41.

La couche de résine époxy 42 permet la mise en contact thermique tout en assurant l'isolation électrique du circuit imprimé en cuivre 41 avec le boîtier 10.

La carte électronique de gestion 40 est disposée de sorte que la couche de résine époxy 42 vient en contact avec la face interne de la paroi 14 du boîtier 10.

Il sera entendu dans la suite que lorsqu'un élément A est mentionné comme étant « sur » un élément B, celui-ci peut être directement sur l'élément B, ou peut être situé au-dessus de l'élément B et séparé de l'élément B par un ou plusieurs autres éléments intermédiaires.

Il sera également entendu que lorsqu'un élément A est mentionné comme étant « sur » un élément B, celui-ci peut couvrir toute la surface de l'élément B, ou une portion de l'élément B.

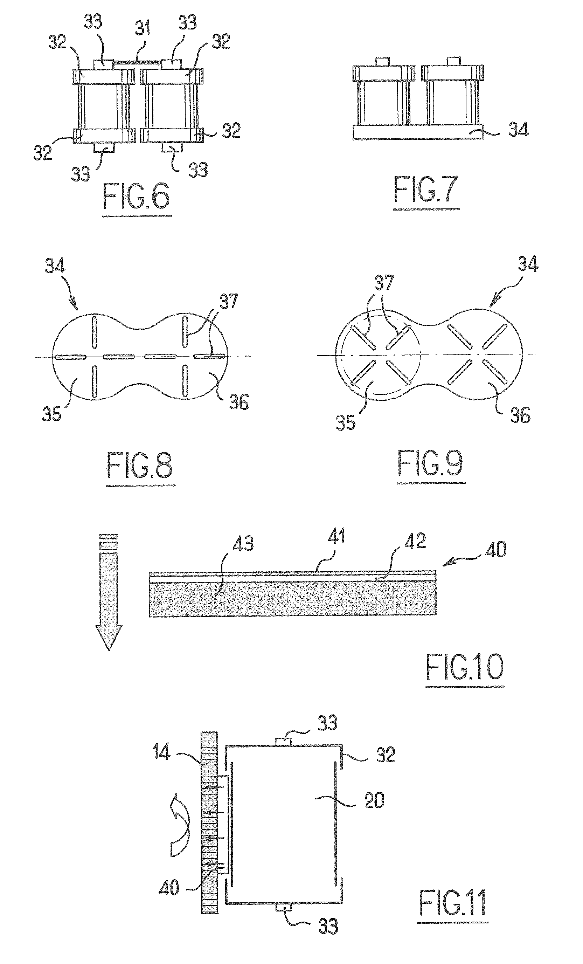

Dans un mode de réalisation illustré à la figure 10, la carte électronique de gestion 40 comprend une plaque en aluminium 43 sur la couche de résine époxy 42 ( de sorte que la couche de résine époxy est située entre le circuit imprimé en cuivre et la couche d'aluminium).

Dans ce cas, c'est la plaque en aluminium qui est mise en contact avec la face interne de la paroi 14 du boîtier 10.

La présence, sur la carte électronique de gestion 40, d'une couche d'aluminium 43 favorise l'évacuation de la chaleur du circuit imprimé 41 en cuivre vers la paroi 14 du boîtier 10 en contact avec la carte électronique de gestion 40.

Dans le mode de réalisation illustré aux figures 3a à 3d, le module comprend quatre cartes électroniques de gestion 40 reliées thermiquement aux faces internes des quatre parois latérales 14 du boîtier 10.

Bien évidemment, les cartes électroniques 40 peuvent être disposées à l'extérieur du boîtier, et donc reliées thermiquement aux faces externes des parois latérales de ce dernier. Une telle disposition peut avoir pour intérêt d'améliorer encore le refroidissement des cartes, et d'en assurer plus facilement la maintenance, sans à avoir à ouvrir le boîtier, mais présente pour inconvénients de les exposer plus facilement aux chocs extérieurs, et de nécessiter une amélioration de l'étanchéité des parois du boîtier

La présence de quatre cartes électroniques sur les quatre parois latérales du module évite que les ensembles de stockage situés à la périphérie du boîtier ne se refroidissent plus vite que les ensembles de stockage 20 situés au centre du boîtier.

En effet, les cartes électroniques 40 jouent dans ce cas le rôle de tampon thermique. La présence de ces tampons thermiques sur les parois latérales induit que les ensembles de stockage 20 disposés à proximité des parois latérales 14 vont refroidir moins rapidement de sorte que tous les ensembles de stockage 20 du module vont refroidir à la même vitesse.

La chaleur étant la principale cause de vieillissement des ensembles de stockage 20, l'homogénéisation de la température à l'intérieur du module induit une homogénéisation du vieillissement des ensembles de stockage 20 du module.

Bien évidemment, le nombre de cartes électroniques sera optimisé en fonction du résultat thermique à obtenir, sans que le nombre de cartes doive obligatoirement être identique au nombre de parois latérales du boîtier, notamment quand le boîtier a une forme circulaire ou complexe liée à l'environnement particulier dans lequel le module est exploité.

### Moyens de connexion

Dans un mode de réalisation illustré à la figure 6, les moyens de connexion 30 entre deux ensembles de stockage 20 adjacents comprennent deux couvercles 32 ou 32' reliés électriquement par une barrette 31.

Chaque couvercle 32, 32' est destiné à coiffer un ensemble de stockage 20.

Chaque couvercle 32, 32' comprend une borne de connexion 33 destinée à être en contact avec un alésage traversant (non représenté) de la barrette 31. Pour améliorer la conduction électrique entre la borne 33 et la barrette 31, l'état de surface de l'alésage traversant peut être rendu rugueux afin d'augmenter la surface de contact.

Dans un mode de réalisation, les barrettes 31 sont en cuivre. Ceci permet de diminuer la résistance ohmique des moyens de connexions 30 et donc de minimiser les pertes par effet Joule. Ainsi, la production de chaleur par les moyens de connexion 30 est réduite à l'intérieur du module.

Dans un autre mode de réalisation, les barrettes 31 sont en aluminium. Ceci permet d'améliorer la masse des moyens de connexion tout en conservant une résistance ohmique entre les ensembles de stockage et une conduction thermique satisfaisante entre les ensembles de stockage 20 et le boîtier 10.

Dans une variante, les barrettes 31 pourront être revêtues d'un traitement de surface de type nickelage ou étamage pour le protéger contre la corrosion, mais aussi d'améliorer le contact électrique

Pour chaque ensemble de stockage 20, le couvercle supérieur 32 de l'ensemble 20 est relié électriquement avec le couvercle supérieur 32 d'un ensemble adjacent, tandis que le couvercle inférieur 32' du même ensemble est relié électriquement avec le couvercle inférieur 32' d'un autre ensemble de stockage adjacent de sorte que chaque ensemble de stockage 20 peut être connecté à deux ensembles de stockage 20 adjacents, l'un au niveau de son couvercle supérieur 32 et l'autre au niveau de son couvercle inférieur 32'.

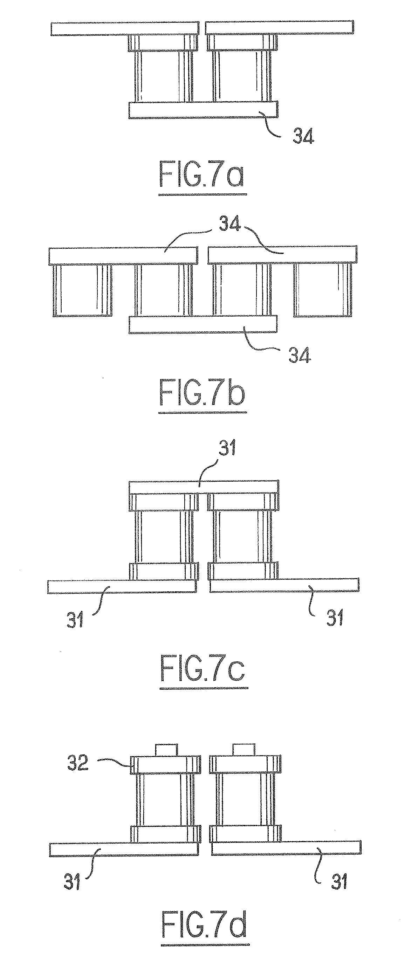

Dans le mode réalisation de la figure 7a, les ensembles de stockage d'énergie possèdent des couvercles plats sans borne de connexion. Ils sont alors soudés ou brasées par paires avec leurs voisins au moyen de barrettes soudées ou brasées dans le même arrangement que décrit au paragraphe précédent. Dans le cas de soudage laser par transparence, les barrettes pourront disposer de zones préférentielles amincies, similaires à celles décrites plus bas à propos du soudage des bi-couvercles

La surface de contact entre la barrette 31 et un couvercle 32 est préférentiellement supérieure ou égale à un quart de la surface du couvercle 32, et encore plus préférentiellement supérieure ou égale à la moitié de la surface du couvercle 32, voire même sur la totalité de la surface du couvercle.

Cette configuration des ensembles de stockage permet de maximiser la surface de contact entre la barrette 31 et le couvercle 32, 32' et donc de favoriser les échanges thermiques entre le couvercle 32, 32' et le boîtier au travers de la barrette 31.

Dans un autre mode de réalisation illustré aux figures 7, 8 et 9, les moyens de connexion 30 comprennent une pièce longitudinale 34 , appelée bi-couvercle, dont les extrémités 35, 36 forment les couvercles supérieurs 32 ou les couvercles inférieurs 32' de deux ensembles de stockage 20 adjacents pour les connecter électriquement.

L'utilisation de la pièce longitudinale 34 pour connecter électriquement deux ensembles de stockage adjacents permet d'accroître les performances électriques et thermiques des modules.

En effet, en ce qui concerne les performances électriques, l'utilisation des moyens de connexion réalisés en une seule pièce permet de diminuer la résistance interne des moyens de connexion (et donc la production de chaleur par effet Joule). En ce qui concerne les performances thermiques, l'utilisation de moyens de connexion en une seule pièce, aptes à former les couvercles supérieurs (ou inférieurs) de deux ensembles de stockage permet d'augmenter la surface de contact entre les ensembles de stockage 20 et les parois du module, ce qui favorise la diffusion thermique vers le boîtier 10.

Dans le cas où, les bi-couvercles sont soudés laser par transparence, chaque extrémité 35, 36 du bi-couvercle 34 comprend zones préférentielles amincies 37 pour former des zones de soudage.

Dans les modes de réalisation illustrés aux figures 8 et 9, les zones préférentielles amincies 37 sont radiales et perpendiculaires deux à deux.

Dans le mode de réalisation illustré à la figure 8, une zone préférentielle amincie 37 de chaque extrémité 35, 36 s'étend selon l'axe longitudinal B-B de la pièce longitudinale 34.

Ceci permet de diminuer la résistance interne de la pièce longitudinale 34 (et donc la production de chaleur par effet Joule des moyens de connexion 30). Toutefois, dans ce cas, le courant circule principalement au niveau des zones amincies rectilignes s'étendant selon l'axe longitudinal B-B de la pièce longitudinale 34. Ceci peut provoquer un échauffement local de la pièce longitudinale au niveau des zones amincies rectilignes s'étendant selon l'axe longitudinal B-B de la pièce longitudinale 34.

Dans le mode de réalisation illustré à la figure 9, les zones amincies rectilignes radiaux 37 sont perpendiculaires deux à deux et ont un angle de 45° avec l'axe longitudinal de la pièce. Ceci permet d'éviter les risques de détérioration liés à l'échauffement local mentionné ci-dessus.

### Alternatives

Le lecteur aura compris que de nombreuses modifications peuvent être apportées au module décrit précédemment.

Par exemple, le nombre d'ensembles de stockage du module peut être supérieur ou inférieur à 20. Par exemple, le module peut comprendre deux ensembles de stockage d'énergie électrique, ou plus de deux ensembles de stockage.

Par exemple, les éléments de stockage d'énergie peuvent être reliés entre eux par des moyens combinés entre ceux décrits plus haut :
- bi-couvercles en bas, et couvercles à bornes en haut (figure 7),
- bi-couvercles en bas, et couvercles plats soudés ou brasés en haut (figure 7a),
- bi-couvercles en bas et en haut (figure 7b),
- barrettes soudées en haut et en bas (figure 7c),
- couvercles à bornes en haut et barrettes soudée en bas (figure 7d),
- couvercles à bornes en haut et en bas (figure 6),
et ceci en fonction contraintes d'assemblage et des besoins de fabrication.

De même, le nombre de cartes électroniques de gestion peut être supérieur ou inférieur à 4. Par exemple, le module peut comprendre une unique carte de gestion.

Dans ce cas, les deux ensembles de stockage sont reliés thermiquement à une première paroi et la carte électronique de gestion est reliée à une deuxième paroi - différente de la première paroi - de manière à augmenter les échanges thermiques avec l'extérieur, et ainsi favoriser l'évacuation de la chaleur produite par les ensembles de stockage, les moyens de connexion et la carte électronique de gestion.

Par ailleurs, dans les différents modes de réalisation décrits ci-dessus, on a présenté :
- les ensembles de stockage comme étant reliés thermiquement soit à la paroi inférieure du boîtier, soit à la paroi supérieure du boîtier, soit aux parois supérieure et inférieure du boîtier, et
- la carte électronique de gestion comme étant reliée à une, deux, trois ou quatre des parois latérales du boîtier.

De la même façon, l'agencement géométrique des éléments de stockage est décrit plus haut en réseau carré, mais peut être également de n'importe quelle forme, comme par exemple triangulaire, parallélogramme, hexagonale, octogonale, etc...

Avantageusement, le lecteur aura compris que les liaisons thermiques des ensembles de stockage et des cartes électroniques de gestion peuvent être inversées, à savoir que :
- les ensembles de stockage peuvent être reliés à une ou plusieurs parois latérales du boîtier, par exemple dans le cas où les éléments de stockage d'énergie seraient agencés à plat de façon à respecter l'évacuation axiale de la chaleur des vers l'extérieur du boîtier. Les cartes électroniques de gestion peuvent être reliées à la paroi supérieure, ou à la paroi inférieure, ou aux parois supérieure et inférieure.

Pour simplifier la description, nous avons décrit des modules s'étendant globalement verticalement. Bien entendu les modules pourraient avoir une orientation quelconque.

Egalement, dans la présente description, les ensembles de stockage et leur orientation a été définie par rapport à des ensembles de stockage comprenant une section circulaire. Bien évidemment, les ensembles de stockage pourraient avoir une section quelconque.

Enfin, les descriptions précédentes ont été proposées en liaison avec une construction de module comprenant un seul niveau d'éléments, mais il est évident qu'elles peuvent également être appliquées à des modules comportant plusieurs couches d'éléments, les échanges thermiques avec le boîtier s'appliquant aux couches externes de l'ensemble.

## Revendications

1. Module comprenant un boîtier (10) dans lequel sont disposés au moins deux ensembles de stockage d'énergie électrique (20) reliés par des moyens de connexion (30) et au moins une carte électronique (40) pour la gestion d'énergie et le diagnostic des ensembles de stockage d'énergie (20),
**caractérisé en ce que**
des parois différentes (12, 13, 14) du boîtier (10) sont en contact thermique tout en étant en isolation électrique respectivement :
- pour au moins une paroi (12, 13) avec des éléments de dissipation thermique liés aux ensembles de stockage d'énergie électrique (20),
- pour au moins une autre paroi (14) avec la carte électronique de gestion (40),
de sorte à favoriser le refroidissement dudit module.

2. Module selon la revendication 1, **caractérisé en ce que** le boîtier (10) comprend des ailettes (15, 15') sur au moins une face extérieure du boîtier (10).

3. Module selon la revendication 2, **caractérisé en ce que** les ailettes (15) sont disposées sur la face externe de la paroi (12, 13) du boîtier (10) en contact thermique avec les éléments de dissipation thermique liés aux ensembles de stockage (20).

4. Module selon l'une des revendications 2 ou 3, **caractérisé en ce que** les ailettes (15') sont disposées sur la face externe de l'autre paroi (14) du boîtier (10) en contact thermique avec la carte électronique de gestion (40).

5. Module selon l'une des revendications 1 à 4, **caractérisé en ce que** le boîtier (10) est en aluminium.

6. Module selon l'une des revendications 1 à 4, **caractérisé en ce que** le boîtier (10) est en matériau composite carboné.

7. Module selon l'une des revendications 1 à 6, **caractérisé en ce que** la paroi (12, 13) en contact avec les éléments de dissipation thermique est la paroi inférieure (13) du boîtier (10) et l'autre paroi (14) en contact avec la carte électronique de gestion (40) est une paroi latérale du boîtier (10).

8. Module selon l'une des revendications 1 à 7, **caractérisé en ce que** la paroi (13) en contact thermique avec les éléments de dissipation thermique comprend ou est associé à un socle dans lequel est disposé un dispositif de refroidissement.

9. Module selon la revendication 8, **caractérisé en ce que** le dispositif de refroidissement comprend un circuit de circulation d'un fluide de refroidissement.

10. Module selon l'une des revendications 1 à 9, **caractérisé en ce que** la carte électronique de gestion (40) comprend une couche de résine époxy (42) sur laquelle est collée un circuit imprimé en cuivre (41).

11. Module selon la revendication 10, **caractérisé en ce que** la couche de résine époxy (42) est en contact avec la face interne de l'autre paroi (14) du boîtier (10).

12. Module selon la revendication 10, **caractérisé en ce que** la carte électronique de gestion (40) comprend une plaque en aluminium (43) sur la couche de résine époxy (42), la plaque en aluminium (43) étant en contact avec la face interne de l'autre paroi (14) du boîtier (10).

13. Module selon l'une des revendications 1 à 12, **caractérisé en ce que** deux parois (12, 13) sont en contact thermique tout en étant en isolation électrique avec les éléments de dissipation thermique liés aux ensembles de stockage d'énergie (20).

14. Module selon la revendication 13, **caractérisé en ce que** les deux parois (12, 13) en contact thermique avec les éléments de dissipation thermique liés aux ensembles de stockage d'énergie (20) sont les parois supérieure (12) et inférieure (13) du boîtier (10).

15. Module selon l'une des revendications 1 à 14, **caractérisé en ce qu'**il comprend au moins une carte électronique de gestion (40), ladite carte électronique de gestion (40) étant en contact avec au moins une paroi latérale (14) du boîtier (10).

16. Module selon la revendication 15, **caractérisé en ce qu'**il comporte autant de cartes électroniques de gestion que le boîtier comporte de parois latérale, chacune desdites cartes étant en contact avec une paroi latérale (14) respective du boîtier (10)

17. Module selon l'une des revendications 15 ou 16, **caractérisé en ce que** les cartes de gestion sont en contact avec la face interne de la paroi latérale du boîtier.

18. Module selon l'une des revendications 15 ou 16, **caractérisé en ce que** les cartes de gestion sont en contact avec la face externe de la paroi latérale du boîtier.

19. Module selon l'une des revendications 1 à 18, **caractérisé en ce que** les moyens de connexion (30) entre deux ensembles de stockage (20) adjacents comprennent deux couvercles (32) reliés électriquement par une barrette (31), chaque couvercle (32) comprenant une borne de connexion (33) destinée à être en contact avec un alésage traversant de la barrette (31).

20. Module selon la revendication 19, **caractérisé en ce que** les barrettes (31) sont en aluminium comportent un étamage ou un nickelage à titre de protection de surface.

21. Module selon l'une des revendications 1 à 18, **caractérisé en ce que** les moyens de connexion (30) entre deux ensembles de stockage (20) adjacents comprennent deux couvercles (32) reliés électriquement par une barrette (31') brasée sur les couvercles (32).

22. Module selon l'une des revendications 19 à 21, **caractérisé en ce que** la surface de contact entre la barrette (31) et un couvercle (32) est supérieure ou égale à un quart de la surface du couvercle (32).

23. Module selon la revendication 17, **caractérisé en ce que** la surface de contact entre la barrette (31) et un couvercle (32) est supérieure ou égale à la moitié de la surface du couvercle (32).

24. Module selon l'une des revendications 1 à 19, **caractérisé en ce que** deux ensembles de stockage (20) adjacents sont reliés électriquement par une pièce longitudinale (34) dont les extrémités (35, 36) forment les couvercles, respectivement supérieurs (32) ou inférieurs (32') de chacun des ensembles de stockage (20) adjacents de manière à connecter électriquement lesdits ensembles de stockage (20) adjacents.

25. Module selon la revendication 24, **caractérisé en ce que** chaque extrémité (35, 36) de la pièce longitudinale (34) comprend des zones préférentielles amincies radiales (37).

26. Module selon l'une des revendications 24 ou 25, **caractérisé en ce que** les zones préférentielles amincies (37) sont perpendiculaires deux à deux et ont un angle de 45° avec l'axe longitudinal (B-B) de la pièce (34).

27. Module selon l'une des revendications 24 ou 25, **caractérisé en ce que** les zones préférentielles amincies (37) sont perpendiculaires deux à deux, au moins une zone (37) de chaque extrémité (35, 36) s'étendant selon l'axe longitudinal (B-B) de la pièce (34).

28. Module selon l'une des revendications 1 à 19, **caractérisé en ce que** les moyens de connexion (30) comprennent les éléments de dissipation thermique (38).

29. Module selon la revendication 28, **caractérisé en ce que** les éléments de dissipation thermique (38) entre les éléments et la paroi du module comprennent une couche d'élastomère.

## Patentansprüche

1. Modul, aufweisend ein Gehäuse (10), in welchem wenigstens zwei Baugruppen zur Speicherung elektrischer Energie (20), die durch Verbindungsmittel (30) verbunden sind, und wenigstens eine Elektronikkarte (40) zur Energieverwaltung und zur Diagnostik der Energiespeicherbaugruppen (20) angeordnet sind,
**dadurch gekennzeichnet, dass**
unterschiedliche Wände (12, 13, 14) des Gehäuses (10) in thermischem Kontakt sind, wobei sie vollständig in elektrischer Isolation sind, jeweils:
- für wenigstens eine Wand (12, 13) mit Wärmeabgabeelementen, die mit den Baugruppen zur Speicherung elektrischer Energie (20) verbunden sind,
- für wenigstens eine andere Wand (14) mit der Elektronikkarte zur Verwaltung (40),
derart, dass die Kühlung des Moduls begünstigt wird.

2. Modul nach Anspruch 1, **dadurch gekennzeichnet, dass** das Gehäuse (10) Rippen (15, 15') auf wenigstens einer Außenseite des Gehäuses (10) aufweist.

3. Modul nach Anspruch 2, **dadurch gekennzeichnet, dass** die Rippen (15) auf der Außenseite der Wand (12, 13) des Gehäuses (10) in thermischem Kontakt mit den Wärmeabgabeelementen angeordnet sind, die mit den Baugruppen zur Speicherung (20) verbunden sind.

4. Modul nach einem der Ansprüche 2 oder 3, **dadurch gekennzeichnet, dass** die Rippen (15') an der Außenseite der anderen Wand (14) des Gehäuses (10) in thermischem Kontakt mit der Elektronikkarte zur Verwaltung (40) vorgesehen sind.

5. Modul nach einem der Ansprüche 1 - 4, **dadurch gekennzeichnet, dass** das Gehäuse (10) aus Aluminium ist.

6. Modul nach einem der Ansprüche 1 - 4, **dadurch gekennzeichnet, dass** das Gehäuse (10) aus Kohlenstoffverbundwerkstoff ist.

7. Modul nach einem der Ansprüche 1 - 6, **dadurch gekennzeichnet, dass** die Wand (12, 13), die mit den Wärmeabgabeelementen in Berührung ist, die untere Wand (13) des Gehäuses (10) ist, und die andere Wand (14), die mit der Elektronikkarte zur Verwaltung (40) in Berührung ist, eine Seitenwand des Gehäuses (10) ist.

8. Modul nach einem der Ansprüche 1 - 7, **dadurch gekennzeichnet, dass** die Wand (13), die mit den Wärmeabgabeelementen in Berührung ist, einen Sockel aufweist oder mit diesem verbunden ist, in welchem eine Kühlvorrichtung angeordnet ist.

9. Modul nach Anspruch 8, **dadurch gekennzeichnet, dass** die Kühlvorrichtung einen Kreis für den Umlauf eines Kühlfluids aufweist.

10. Modul nach einem der Ansprüche 1 - 9, **dadurch gekennzeichnet, dass** die Elektronikkarte zur Verwaltung (40) eine Epoxidharzschicht (42) aufweist, auf welche eine gedruckte Schaltung aus Kupfer (41) geklebt ist.

11. Modul nach Anspruch 10, **dadurch gekennzeichnet, dass** die Epoxidharzschicht (42) mit der Innenfläche der anderen Wand (14) des Gehäuses (10) in Berührung ist.

12. Modul nach Anspruch 10, **dadurch gekennzeichnet, dass** die Elektronikkarte zur Verwaltung (40) eine Aluminiumplatte (43) auf der Epoxidharzschicht (42) aufweist, wobei die Aluminiumplatte (43) in Berührung mit der Innenfläche der anderen Wand (14) des Gehäuses (10) ist.

13. Modul nach einem der Ansprüche 1 - 12, **dadurch gekennzeichnet, dass** zwei Wände (12, 13) in thermischem Kontakt und gleichzeitig elektrisch isoliert von den Wärmeabgabeelementen sind, die mit den Energiespeicherbaugruppen (20) verbunden sind.

14. Modul nach Anspruch 13, **dadurch gekennzeichnet, dass** die beiden Wände (12, 13), die mit den mit den Energiespeicherbaugruppen (20) verbundenen Wärmeabgabeelementen in thermischem Kontakt sind, die obere Wand (12) und die untere Wand (13) des Gehäuses (10) sind.

15. Modul nach einem der Ansprüche 1 - 14, **dadurch gekennzeichnet, dass** es wenigstens eine Elektronikkarte zur Verwaltung (40) aufweist, wobei die Elektronikkarte zur Verwaltung (40) in Berührung mit wenigstens einer Seitenwand (14) des Gehäuses (10) ist.

16. Modul nach Anspruch 15, **dadurch gekennzeichnet, dass** es so viele Elektronikkarten zur Verwaltung aufweist, wie das Gehäuse Seitenwände aufweist, wobei jede der Karten in Berührung mit einer zugehörigen Seitenwand (14) des Gehäuses (10) in Berührung sind.

17. Modul nach einem der Ansprüche 15 oder 16, **dadurch gekennzeichnet, dass** die Karten zur Verwaltung mit einer Innenfläche der Seitenwand des Gehäuses in Berührung sind.

18. Modul nach einem der Ansprüche 15 oder 16, **dadurch gekennzeichnet, dass** die Karten zur Verwaltung mit der Außenseite der Seitenwand des Gehäuses in Berührung sind.

19. Modul nach einem der Ansprüche 1 - 18, **dadurch gekennzeichnet, dass** die Verbindungsmittel (30) zur Verbindung zwischen zwei benachbarten Speicherbaugruppen zwei Deckel (32) aufweisen, die durch eine Klemmenleiste (31) elektrisch verbunden sind, wobei jeder Deckel (32) eine Verbindungsklemme (33), bestimmt für ein In-Berührung-Sein mit einer Druchgangsbohrung der Klemmenleiste (31) aufweist.

20. Modul nach Anspruch 19, **dadurch gekennzeichnet, dass** die Klemmenleisten (31) aus Aluminium sind und eine Verzinnung oder Vernickelung als Oberflächenschutz aufweisen.

21. Modul nach einem der Ansprüche 1 - 18, **dadurch gekennzeichnet, dass** die Verbindungsmittel (30) zur Verbindung zwischen zwei benachbarten Speicherbaugruppen (20) zwei Deckel (32) aufweisen, die über eine auf die Deckel (32) gelötete Klemmenleiste (31') elektrisch verbunden sind.

22. Modul nach einem der Ansprüche 19 - 21, **dadurch gekennzeichnet, dass** die Berührfläche zwischen der Klemmenleiste (31) und einem Deckel (32) größer oder gleich ein Viertel der Fläche des Deckels (32) ist.

23. Modul nach Anspruch 17, **dadurch gekennzeichnet, dass** die Berührfläche zwischen der Klemmenleiste (31) und einem Deckel (32) größer oder gleich die Hälfte der Fläche des Deckels (32) ist.

24. Modul nach einem der Ansprüche 1 - 19, **dadurch gekennzeichnet, dass** zwei benachbarte Speicherbaugruppen (20) durch ein Längsteil (34) elektrisch verbunden sind, dessen Enden (35, 36) die oberen (32) bzw. unteren (32') Deckel einer jeden der benachbarten Speicherbaugruppen (20) bilden, derart, dass die benachbarten Speicherbaugruppen (20) elektrisch verbunden werden.

25. Modul nach Anspruch 24, **dadurch gekennzeichnet, dass** jedes Ende (35, 36) des Längsteils (34) Präferenzzonen mit radialer Verjüngung (37) aufweist.

26. Modul nach einem der Ansprüche 24 oder 25, **dadurch gekennzeichnet, dass** die Präferenzzonen mit radialer Verjüngung (37) paarweise senkrecht sind und einen Winkel von 45° mit der Längsachse (B-B) des Teils (34) einschließen.

27. Modul nach einem der Ansprüche 24 oder 25, **dadurch gekennzeichnet, dass** die Präferenzzonen mit radialer Verjüngung (37) paarweise senkrecht sind, wobei wenigstens eine Zone (37) eines jeden Endes (35, 36) sich gemäß der Längsachse (B-B) des Teils (34) erstreckt.

28. Modul nach einem der Ansprüche 1 - 19, **dadurch gekennzeichnet, dass** die Verbindungsmittel (30) die Wärmeabgabeelemente (38) aufweisen.

29. Modul nach Anspruch 28, **dadurch gekennzeichnet, dass** die Wärmeabgabeelemente (38) zwischen den Elementen und der Wand des Moduls eine Elastomerschicht aufweisen.

## Claims

1. Module comprising a casing (10) in which at least two electric energy storage assemblies (20) are arranged and connected by connection means (30), and at least one electronic board (40) for energy management and diagnosis of the energy storage assemblies (20), **characterized in that**
different walls (12, 13, 14) of the casing (10), are in thermal contact with, whilst being electrically insulated from, respectively:
- regarding at least one wall (12, 13), with heat dissipation elements connected to the electric energy storage assemblies (20),
- regarding at least one other wall (14), with the electronic management bard (40)
so as to promote cooling of said module.

2. Module according to claim 1, **characterized in that** the casing (10) comprises fins (15, 15') on at least one outer face of the casing (10).

3. Module according to claim 2, **characterized in that** the fins (15) are arranged on the outer face of the wall (12, 13) of the casing (10) in thermal contact with the heat dissipation elements connected to the storage assemblies (20).

4. Module according to either of claims 2 or 3, **characterized in that** the fins (15') are arranged on the outer face of the other wall (14) of the casing (10) in thermal contact with the electronic management board (40).

5. Module according to any of claims 1 to 4, **characterized in that** the casing (10) is in aluminium.

6. Module according to any of claims 1 to 4, **characterized in that** the casing (10) is in carbon composite material.

7. Module according to any of claims 1 to 6, **characterized in that** the wall (12, 13) in contact with the heat dissipation elements is the lower wall (13) of the casing (10) and the other wall (14) in contact with the electronic management board (40) is a side wall of the casing (10).

8. Module according to any of claims 1 to 7, **characterized in that** the wall (13) in thermal contact with the heat dissipation elements comprises or is associated with a base in which a cooling device is arranged.

9. Module according to claim 8, **characterized in that** the cooling device comprises a circulation circuit for a cooling liquid.

10. Module according to any of claims 1 to 9, **characterized in that** the electronic management board (40) comprises a layer of epoxy resin (42) on which a copper printed circuit (41) is bonded.

11. Module according to claim 10, **characterized in that** the epoxy resin layer (42) is in contact with the inner face of the other wall (14) of the casing (10).

12. Module according to claim 10, **characterized in that** the electronic management board (40) comprises an aluminium plate (43) on the epoxy resin layer (42), the aluminium plate (43) being in contact with the inner face of the other wall (14) of the casing (10).

13. Module according to any of claims 1 to 12, **characterized in that** the two walls (12, 13) are in thermal contact with, whilst being electrically insulated from, the heat dissipation elements connected to the energy storage assemblies (20).

14. Module according to claim 13, **characterized in that** the two walls (12, 13) in thermal contact with the heat dissipation elements connected to the energy storage assemblies (20) are the upper (12) and lower (13) walls of the casing (10).

15. Module according to any of claims 1 to 14, **characterized in that** it comprises at least one electronic management board (40), said electronic management board (40) being in contact with at least one side wall (14) of the casing (10).

16. Module according to claim 15, **characterized in that** it comprises as many electronic management boards as the casing has side walls, each of said boards being in contact with a respective side wall (14) of the casing (10).

17. Module according to either of claims 15 or 16, **characterized in that** the management boards are in contact with the inner face of the side wall of the casing.

18. Module according to either of claims 15 or 16, **characterized in that** the management boards are in contact with the outer face of the side wall of the casing.

19. Module according to any of claims 1 to 18, **characterized in that** the connection means (30) between two adjacent storage assemblies (20) comprise two covers (32) electrically connected by a terminal strip (31), each cover (32) comprising a connection terminal (33) intended to be in contact with a through borehole of the terminal strip (31).

20. Module according to claim 18, **characterized in that** the terminal strips (31) in aluminium comprise tin-plating or nickel-plating as surface protection.

21. Module according to any of claims 1 to 18, **characterized in that** the connection means (30) between two adjacent storage assemblies (20) comprise two covers (32) electrically connected by a terminal strip (31') brazed onto the covers (32).

22. Module according to any of claims 19 to 21, **characterized in that** the contact surface between the terminal strip (31) and a cover (32) is equal to or more than one quarter of the surface of the cover (32).

23. Module according to claim 17, **characterized in that** the contact surface between the terminal strip (31) and a cover (32) is equal to or more than one half of the surface of the cover (32).

24. Module according to any of claims 1 to 19, **characterized in that** two adjacent storage assemblies (20) are electrically connected by a longitudinal part (34) whose ends (35, 36) form the respective upper (32) or lower (32') covers of each of the adjacent storage assemblies (20), so as electrically to connect said adjacent storage assemblies (20).

25. Module according to claim 24, **characterized in that** each end (35, 36) of the longitudinal part (34) comprises preferential radial thinned regions (37).

26. Module according to either of claims 24 or 25, **characterized in that** the preferential thinned regions (37) are perpendicular two by two and have an angle of 45° with the longitudinal axis (B-B) of part (34) .

27. Module according to either of claims 24 or 25, **characterized in that** the preferential thinned regions (37) are perpendicular two by two, at least one region (37) of each end (35, 36) extending along the longitudinal axis (B-B) of part (34).

28. Module according to any of claims 1 to 19, **characterized in that** the connection means (30) comprise the heat dissipation elements (38).

29. Module according to claim 28, **characterized in that** the heat dissipation elements (38) between the elements and the wall of the module comprise a layer of elastomer.
